Europäisches Patentamt

European Patent Office

Office européen des brevets

(19)

(11) Publication number: **0 1 1 3 785**
A1

# EUROPEAN PATENT APPLICATION

published in accordance with Art. 158(3) EPC

(21) Application number: **83902292.8**

(22) Date of filing: **25.07.83**

Data of the international application taken as a basis:

(86) International application number:
**PCT/JP 83/00238**

(87) International publication number:
**WO 84/00555 (16.02.84 84/5)**

(51) Int. Cl.³: **C 08 L 27/06,** C 08 L 55/02,
C 08 K 7/02, H 01 B 7/18

(30) Priority: **26.07.82 JP 130736/82**

(43) Date of publication of application: **25.07.84**
**Bulletin 84/30**

(84) Designated Contracting States: **AT BE CH DE FR GB LI NL SE**

(71) Applicant: **DAINICHI-NIPPON CABLES, LTD., 8, Nishino-cho Higashimukaijima Amagasaki-shi, Hyogo-ken 660 (JP)**

(72) Inventor: **ITO, Hirotaka Dainichi-Nippon Cables, Ltd., 8, Higashimukaijimanishino-cho, Amagasaki-shi Hyogo 660 (JP)**
Inventor: **KUSUI, Akio Dainichi-Nippon Cables, Ltd., Itami Kojo 3 Ikejiri 4-chome, Itami-shi Hyogo 664 (JP)**

(74) Representative: **Warden, John Christopher et al, R.G.C. Jenkins & Co. 12-15, Fetter Lane, London EC4A 1PL (GB)**

(54) **COMPOSITION FOR SHIELDING ELECTROMAGNETIC WAVE.**

(57) A composition for shielding electromagnetic wave, which is a mixture of at least one member selected from the group consisting of plasticized vinyl chloride resin and acrylonitrile/butadiene/styrene resin and copper or copper alloy fibers of 1 to 100 µm in diameter and 0.5 to 10 mm in length, the content of said fibers being 30 to 70 wt.%. This composition shows excellent electromagnetic wave-shielding properties and injection molding properties.

EP 0 113 785 A1

0113785

SPECIFICATION

Composition for Use in Electromagnetic Wave Shielding

## Field of the Art

This invention relates to a composition for use in electromagnetic wave shielding suitable for electronic apparatuses, and electronic parts, etc. and excellent in injection moldability.

## Background of the Art

In order to industrially manufacture at low cost a bus cable for interface used for connecting electronic parts such as peripheral units for personal computers and least subject to leaking electric wave, it is necessary to insulate the connection between cores and terminals of the bus cable and to cover the thus insulated connection with an electromagnetic shielding material by injection molding. But because the shielding material heretofore proposed was insufficient in point of fluidity above the melting point or softening point of a base polymer, there was a problem in that it was difficult to make injection molding of the shielding material to the shape specified by a metal mold or in that the molded material smooth on the surface was impossible of obtainment.

## Disclosure of the Invention

In view of the problems described above, this invention proposes a novel composition for use in electromagnetic wave shielding excellent both in electromagnetic wave shieldability and in injection moldability. The composition proposed is characterized in that the composition comprises at least one kind selected from a group consisting of plasticized vinyl chloride resin and acrylonitrile-butadiene-styrene resin and a fiber consisting of copper or a copper alloy of a diameter of 1 - 100 $\mu$m and a length of 0.5 - 10 mm and in that the fiber contained in the composition amounts to 30 - 70 % by weight.

As a plasticized vinyl chloride resin used by the invention there may be used a vinyl chloride resin such as vinyl chloride homopolymer, vinyl chloride copolymer, or internally plasticized vinyl chloride copolymer etc, plasticized by the use of a plasticizer or an organic high polymer compatible with vinyl chloride resin, and particularly the one in which the viscosity at a temperature of 180°C measured by Brabender plastograph (unit; m - g, in the invention, all the viscosity values will hereinafter be referred to as those measured by this method and temperature conditions) is 50 - 3,000 m - g, more particularly 100 - 2,000 m - g is suitably used, since it shows excellent injection moldability in the state in which metal fiber to be later described is compounded in large quantities.

As the above-mentioned vinyl chloride homopolymer there may be used the one produced by a conventional known polymerization process such as ordinary suspension polymerization, emulsion polymerization, bulk polymerization or solution polymerization, and particularly the one whose mean degree of polymerization ($\bar{P}$) is 300 - 2,000, especially 400 - 1,100 is desirable for injection molding.

As the above-mentioned vinyl chloride copolymer there may be used various copolymers produced by the above conventional process, and one which is desirable for injection molding of these copolymers has the characteristic in that a) vinyl chloride content is at least 50 % by weight and particularly at least 80 % by weight, b) viscosity is lower than that of vinyl chloride homopolymer, and c) mean degree of polymerization is 300 - 2,000 and especially 400 - 1,100. Such vinyl chloride copolymer includes 1) copolymers of vinyl chloride with at least one kind of monomer capable of effecting radical polymerization with vinyl chloride, for example, olefin, diene, unsaturated carboxylic acid and its esteric derivatives, unsaturated nitryl, aromatic vinyl and its derivatives; 2) graft polymers obtained by grafting upon vinyl chloride homopolymer or the above vinyl chloride copolymer at least one kind of monomer

- 3 -

capable of effecting radical polymerization with the above vinyl chloride; 3) copolymers of vinyl chloride and polymer copolymerizable with vinyl chloride, for example, olefin-vinyl ester copolymer such as ethylene-vinyl acetate copolymer, olefin-alkylacrylate copolymer such as ethylene-methylacrylate, olefin-alkyl methacrylate copolymer such as ehtylene methyl methacrylate, polyolefin type polymer such as polyethylene, ethylene-propylene copolymer, ethylene-propylene copolymer, chlorinated polyethylene and chloro-sulfonated polyethylene, polyether type polymer such as ethylene epichlorohydrine copolymer, diene type elastomer such as polybutadiene and polyisoprene, acrylonitrile-butadiene-styrene copolymer, methyl methacrylate-butadiene-styrene copolymer, etc.; 4) copolymers of vinyl chloride and at least one kind of the above polymers copolymerizable with vinyl chloride and at least one kind of above monomers capable of effecting radical polymerization with vinyl chloride.

Of the above substance, particularly a copolymer of vinyl chloride and a monomer capable of effecting radical polymerization with vinyl chloride is desirable, and in addition, the copolymer which is 80 - 99.5 % by weight in vinyl chloride content is particularly desirable.

As a plasticizer there may be used a conventional pasticizer of vinyl chloride resin, for example, esters

- 4 -

phthalate such as di 2-ethylhexyl phthalate, di n-octyl phthalate, diisodecyl phthalate, diisonyl phthalate and mixed basic ester phthalate having 7 - 11 carbons; 2) esters phosphate such as tricresyl phosphate, triphenyl phosphate, trioctyl phosphate, cresyldiphenyl phosphate; 3) aromatic carboxylic acid esters, such as ester trimelliticate such as octyl trimelliticate, ester trimesicate, ester pyromelliate; 4) aliphatic dibasic esters such as diethyl adipicate, diisodecyl adipicate, dioctyl sebacicate; 5) polyesters of adpinic acid or sebacic acid; and 6) chlorinated paraffins.

The amount of the plasticizer described above for plasticizing vinyl chloride resin to have the viscosity mentioned above can easily be determined by an experiment, but generally, the amount of use of this plasticizer is 10 - 80 parts per 1,000 parts by weight of vinyl chloride resin.

As an organic high polymer compatible with vinyl chloride resin and being able to plasticize the vinyl chrolide resin, there may be used, for example, acrylonitrile-butadiene rubber, thermoplastic urethane, thermoplastic polyester, ethylene-vinyl acetate copolymer containing vinyl acetate in high content of, say, more than 35 % by weight, and the like. The mentioned organic high polymers may be mixed with vinyl chloride resin

- 5 -

single or in combination with one of the plasticizers mentioned above.

Of the vinyl chloride copolymers mentioned above, those which are within the above range may be used singly as internally plasticized vinyl chloride resins.

The various plasticized polyvinyl chloride resins of the type described above which are used by the invention may be used in single or in mixture of more than two kinds. In addition, one or more than two kinds of ordinary chemical agents may be compounded such as a stabilizer, lubricant, pigment, flame retarder, if necessary, which are usually compounded with vinyl chloride resin. However, it is to be noted that the amount of the chemical agent should be such that the viscosity of vinyl chloride resin obtained by the compounding should be limited within the range described above.

As the stabilizing agent may be used such a stabilizer which is usually be used for molding vinyl chloride resins, for example, 1) lead type stabilizers such as dibasic lead sulfate, dibasic lead phosphonate, dibasic lead stearate; 2) tin type stabilizers such as dibutyl tin laurate, dibutyl tin maleate, dibutyl tin fumarate; 3) complex stabilizers such as Ba·Zn complex stabilizer, Ba·Ca complex stabilizer, and so on.

- 6 -

As the flame retarder are used such conventional ones used in vinyl chloride resin, for example, antimony trioxide, alumina hydrate, etc.

In the invention, as an acrylonitrile-butadiene-styrene copolymer used in the form of a base polymer can be used such a one as that manufactured by a polymer blending process such as kneading-mixing process, latex mixing process or a graft polymerization process such as emulsion polymerization, bulk polymerization, suspension polymerization, or the like process. Into the acrylonitrile-butadiene-styrene copolymer can be compounded, if necessary, ordinary chemical agents such as pigment and oxidation retarder in usual amounts.

The copper or copper alloy used in the invention is pure copper or a copper alloy such as an alloy of copper with at least one kind of elements such as zinc, tin, lead, phosphor, iron, manganese, aluminum, nickel, silicium, beryllium, silver, tellurium, cadmium, chromium, selenium, zirconium, and an alloy having a copper content of at least 50 % by weight is used, for example, electrolytic copper, deoxidized copper, oxygen free copper, free cutting copper, red copper, brass, bronze, Corson alloy, Heussler alloy, German silver, cupro-nickel, beryllium copper, silver copper, chromium copper, and the like.

Fiber made of the above-mentioned copper or copper alloy and having a diameter of 1 - 100 $\mu$m and a length of 0.5 - 10 mm is superior in softness or pliability to other metal fiber and is also superior in kneading and mixing property with respect to vinyl chloride resin and acrylonitrile-butadiene-styrene resin, so that the copper or the copper alloys mentioned above are both essential and excellent for the production of composition of the invention which is excellent both in injection moldability and in electroconductivity.

Copper alloys particularly desirable from the point of softness or pliability of fiber and of injection moldability consists essentially of copper and zinc, whose weight ratio of copper to zinc is 95:5 - 60:40, particularly 80:20 - 65:35.

The composition of the invention comprises plasticized vinyl chloride resin (for example, consisting of vinyl chloride resin and a plasticizer) and/or acrylonitrile-butadiene-styrene copolymer, copper or copper alloy fiber, and other chemicals compounded, if necessary, and the quantity of the copper or copper alloy fiber contained in the composition of the invention is 30 - 70 % by weight.

When the copper or copper alloy fiber is shorter in length than 0.5 mm or smaller in the amount of use than 30 % by weight, it is reduced in conduction effect, and on the other hand, when the fiber used is larger in length than 10 mm or larger in diameter than 100 $\mu$m, an injection molder is clogged up, or when it is larger in the amount of use than 70 % by weight, the composition increases extremely in viscosity enough to decrease injection moldability in either case. Also, when the fiber used is finer in diameter than 1 $\mu$m, it is cut and reduced in length in time of mixing with plasticized vinyl chloride resin, with the result that the composition is reduced in conductivity.

When the composition of the invention is 0.005 - 0.5 $\Omega$ cm, particularly 0.005 - 0.1 $\Omega$ cm in volume resistivity, it goes so far as to involve good surface conductivity and especially it produces an electromagnetic wave shielding effect. On the other hand, when the composition of the invention is 100 - 5,000 m - g, particularly 200 - 2,000 m - g in viscosity, it provides especially excellent injection moldability. It is possible to produce the composition of the invention having the above property by controlling the size of the fiber to be used and the amount of use. Desirable copper or copper alloy fiber is 20 - 80 $\mu$m and particularly

- 9 -

40 - 60 μm in diameter and 1 - 6 mm, particularly 2 - 4 mm in length. Also, the amount of use of the fiber is preferably 35 - 65 % by weight and particularly 40 - 60 % by weight.

The composition of the invention may be mixed and produced by a general mixer such as two-roll mixer, Banbury mixer (trade name) in such various ways of addition that a plasticizer, copper or copper alloy fiber and other chemicals are altogether added to vinyl chloride resin or that vinyl chloride resin is beforehand plasticized by a plasticizer and then the remaining chemical agent is added to the plasticized vinyl chloride resin.

Because it is excellent in electromagnetic wave shielding property and injection molding property, the composition of the invention is suitable for use in covering, by injection molding, the leaking wave generating portion of various electronic apparatuses and electronic parts which causes radio wave interference. Particularly, when the composition of the invention is used as a shielding material of a connector for a bus cable for interface for personal computers which in recent years have steadily been increasing in use at general homes, the invention composition can make a great improvement in the prevention of wave interference caused

- 10 -

by electromagnetic wave leak from conventional connectors as in radio receivers and television sets.

<p align="center">Preferred Embodiments of the Invention</p>

A detailed description will now be given of the invention with reference to the examples thereof and contrast examples. Symbols for the compositions used in the invention examples and contract examples, and contents of the compositions are shown in Table 1 in which the part and percentage used are represented by part by weight and percent by weight, respectively.

Table 2 shows compositions and properties of the invention examples (Example Nos. 1 - 23) and contrast examples (Contrast Example Nos. 1 - 10). Furthermore, compounding ratio shown in base polymer composition in the Table represents part by weight, and percentage of metal fiber represents percent by weight of the fiber contained in the invention and contrast example. All the constituents, except the metal fiber, of the composition in each example are sufficiently mixed by two rolls which were beforehand controlled to a temperature of 180°C, and then the metal fiber was added to the thus sufficiently mixed composition on the two rolls, and mixing was continued to obtain an intended composition.

<p align="center">- 11 -</p>

Characteristics of the invention and contrast examples were determined and rated by the following processes.

Injection Moldability:

For rating of injection moldability a bus cable for interface in personal computers was prepared for the bus cable. The cable was constructed in the manner that a layer of shielding braid was placed on a bundle of 24 cores, a connector having 25 contacts was mounted at both ends of a multicore cable of 1.5 mm in outer diameter having thereover a protective sheath consisting of vinyl chloride homopolymer containing a plasticizer, a conductor of each core is directly connected to each contact, and the copper shielding braid was connected through a drainage wire to one remaining contact.

The surface of the above connection portions was insulated. In this state, the invention and contrast examples were injection-molded on the surface of the connector at both ends of the bus cable placed in the mold controlled to temperatures of 50°C - 70°C and on the surface of a part of the cable continuing from the connector, by the use of a 2.5 oz. injection molder having a nozzle diameter of 2.5 mm, under the conditions of a barrel temperature of 180°C and an extrusion pressure of

50 kg/cm$^2$. The results of the examples are shown in five steps as follows.

Grade A (excellent) ...  There is no dimensionally broken portion and gloss and smoothness on the surface are also good.

Grade B (good) ...  There is no dimensionally broken portion and the surface is smooth but slightly lacking in gloss.

Grade C (rather good) ...  There is no dimensionally broken portion but there are partially coarse portions on the surface.

Grade D (passable) ...  There is no dimensionally broken portion in the portion near the terminal end portions of resin flow path inside the metal mold and in the bellows portion at the joint of the cable.  In addition, most of the surface is rough.

Grade E  (no good) ...  The nozzle is stopped up, or too high viscosity makes injection molding impossible.

Volume Resistivity:

The composition was subjected to press forming under the conditions of a temperature of 180°C, a pressure of 100 kg/cm$^2$ and a period of 5 min. and was determined by a process specified in ASTM D-991-68 per sheet of 1 mm in diameter and 10 cm both in length and in width.

Electromagnetic Wave Shielding Property:

Shielding effect was determined on each bus cable obtained from rating of the injection moldability by the absorption clamp process in accordance with IEC CISPR Pub. 16. Incidentally, a bus cable before a shielding material was injection-molded over the cable was used as a control (see Table 2).

Table 1

| | Abbreviations | Contents |
|---|---|---|
| Organic High Polymer Constituting a Base of Composition | PVC1 | Vinyl chloride homopolymer ($\overline{P}$: 1500) |
| | PVC2 | " ($\overline{P}$: 800) |
| | PVC3 | " ($\overline{P}$: 600) |
| | VCVA1 | Vinyl chloride-vinyl acetate copolymer ($\overline{P}$: 1100, VC: 98 %) |
| | VCVA2 | " ($\overline{P}$: 800, VC: 98 %) |
| | VCE1 | Vinyl chloride-ethylene copolymer ($\overline{P}$: 1100, VC: 98 %) |
| | VCE2 | " ($\overline{P}$: 600, VC: 97 %) |
| | VCE3 | " ($\overline{P}$: 1100, VC: 93 %) |
| | VCU | Vinyl chloride-urethane copolymer ($\overline{P}$: 1100, VD: 50 %) |
| | EVAVC | Ethylene-vinyl acetate-vinyl chloride graft copolymer ($\overline{P}$: 1100, VC: 50 %, VA: 25 %, E: 25 %) |
| | ABS | Acrylonitrile-butadiene-styrene copolymer |
| | PE | Polyethylene (d: 0.925, MI: 1) |
| Plasticizer or High Organic Polymer for Use in Plasticization | DOP | Di n-octyl phthalate |
| | DIDP | Diisodecyl phthalate |
| | TOTM | Trioctyl trimelliticate |
| | DINP | Diisononyl phthalate |
| | TCP | Tricresyl phosphate |
| | TOP | Trioctyl phosphate |
| | TPP | Triphenyl phosphate |
| | NBR | Acrylonitrile-butadiene rubber |

(continued)

- 15 -

# 0113785

|  | Abbreviations | Contents |
|---|---|---|
| Metal Fiber | Brass 1 | 7/3 brass (diameter: 30 $\mu$m, length: 6 mm) |
|  | Brass 2 | " (diameter: 50 $\mu$m, length: 4 mm) |
|  | Brass 3 | " (diameter: 60 $\mu$m, length: 2 mm) |
|  | Brass 4 | 6/4 brass (diameter: 50 $\mu$m, length: 4 mm) |
|  | Brass 5 | " (diameter: 60 $\mu$m, length: 2 mm) |
|  | Brass 6 | Naval brass (diameter: 50 $\mu$m, length: 3 mm) |
|  | Brass 7 | 7/3 brass (diameter: 0.5 $\mu$m, length: 5 mm) |
|  | Brass 8 | " (diameter: 200 $\mu$m, length: 3 mm) |
|  | Brass 9 | " (diameter: 10 $\mu$m, length: 0.1 mm) |
|  | Brass 10 | " (diameter: 50 $\mu$m, length: 30 mm) |
|  | Red copper 1 | 9/1 red copper (diameter: 50 $\mu$m, length: 3 mm) |
|  | Red copper 2 | " (diameter: 60 $\mu$m, length: 1 mm) |
|  | Pure copper 1 | Electrolytic copper (diameter: 20 $\mu$m, length: 6 mm) |
|  | Pure copper 2 | " (diameter: 60 $\mu$m, length: 2 mm) |
|  | Al | Pure aluminum (diameter: 50 $\mu$m, length: 3 mm) |
|  | Ni | Pure nickel (diameter: 50 $\mu$m, length: 3 mm) |

(continued)

| | Abbreviations | Contents |
|---|---|---|
| Other Chemicals | $Sb_2O_3$ | Antimony trioxide |
| | AO | Alumina hydrate, $Al_2O_3 \cdot 3H_2O$ |
| | TS | Tribasic lead sulfate |
| | LFOS | Dibasic lead phosphonate |
| | ABT | Ba-Zn dibutyl tin laurate |
| | Ba·Zn | Ba-Zn compound stabilizer (produced by Nippon Ink K.K. under the trade name "INSTAS TARB M 7268 T") |
| | SA | Stearic acid |

Note: The symbol $\bar{P}$ represents mean degree of polymerization; VC content of vinyl chloride constituent; VA content of vinyl acetate constituent; E content of ethylene constituent; d density; and MI represents a melt index.

- 17 -

Table 2-1

| | | Control | Contrast Example 1 | Contrast Example 2 | Contrast Example 3 | Contrast Example 4 | Contrast Example 5 | Contrast Example 6 |
|---|---|---|---|---|---|---|---|---|
| Composition | Base Composition (part by wt.) | – | PE ... 100 | PVC 1 ... 100<br>DOP ..... 50<br>TS ...... 5<br>SA ...... 1 | same as left | VCVA ... 100<br>DIDP ... 50<br>DBL .... 5<br>SA ..... 1 | same as left | same as left |
| | Metal Fiber (% by weight) | – | Brass 1<br>50 | $A\ell$<br>50 | Ni<br>50 | Brass 1<br>20 | Brass 1<br>80 | $A\ell$<br>80 |
| Characteristics | Injection Moldability | – | good | not good | good | excellent | good | not good |
| | Volume Resistivity $\Omega$ cm | – | $6 \times 10^{-1}$ | $4 \times 10^{-1}$ | $3.5 \times 10^{-1}$ | $2 \times 10^{2}$ | $8 \times 10^{-2}$ | $9 \times 10^{-2}$ |
| | Electromagnetic Wave Shielding Effect (dB) — 30 MHz | 10 | 50 | – | 56 | 23 | 70 | – |
| | 100 MHz | 10 | 50 | – | 56 | 18 | >70 | – |
| | 300 MHz | 10 | 50 | – | 60 | 13 | >70 | – |
| | 500 MHz | 15 | 55 | – | 60 | 17 | >70 | – |
| | 1000 MHz | 20 | 60 | – | 70 | 20 | >70 | – |
| | Viscosity (m – g) | – | 5400 | 6200 | 5350 | 1300 | 5450 | 7100 |

Table 2-2

| | | Contrast Example 7 | Contrast Example 8 | Contrast Example 9 | Contrast Example 10 |
|---|---|---|---|---|---|
| Composition | Base Composition (part by wt.) | VCVA1 ... 100<br>DZDP .... 50<br>DBL ..... 5<br>TS ...... 3 | same as left | same as left | same as left |
| | Metal Fiber (% by weight) | brass 7<br>50 | brass 8<br>50 | brass 9<br>50 | brass 10<br>50 |
| Characteristics | Injection Moldability | excellent | not good | excellent | not good |
| | Volume Resistivity $\Omega$ cm | $1 \times 10^1$ | $3 \times 10^{-2}$ | $1.5 \times 10^1$ | $4 \times 10^{-2}$ |
| | Electromagnetic Wave Shielding Effect (dB) 30 MHz | 12 | – | 13 | – |
| | 100 MHz | 14 | – | 12 | – |
| | 300 MHz | 13 | – | 15 | – |
| | 500 MHz | 18 | – | 16 | – |
| | 1000 MHz | 15 | – | 16 | – |
| | Viscosity (m – g) | 1400 | 1700 | 1450 | 1750 |

Table 2-3

| | | Example 1 | Example 2 | Example 3 | Example 4 | Example 5 | Example 6 | Example 7 |
|---|---|---|---|---|---|---|---|---|
| **Composition** | Base Composition (part by wt.) | VCVA1 ... 100<br>DOP ..... 50<br>TS ...... 5<br>SA ...... 3 | same as left | same as left | same as left | same as left | same as left | same as left |
| | Metal Fiber (% by weight) | brass 1<br>40 | brass 1<br>50 | brass 1<br>60 | brass 2<br>48 | brass 3<br>48 | brass 4<br>48 | brass 5<br>48 |
| **Characteristics** | Injection Moldability | excellent | excellent | excellent | excellent | excellent | excellent | excellent |
| | Volume Resistivity $\Omega$ cm | $9 \times 10^{-2}$ | $6 \times 10^{-2}$ | $1 \times 10^{-2}$ | $2.5 \times 10^{-2}$ | $5.5 \times 10^{-2}$ | $3 \times 10^{-2}$ | $4.4 \times 10^{-2}$ |
| | Electromagnetic Wave Shielding Effect (dB) — 30 MHz | 70 | >70 | >70 | >70 | >70 | >70 | >70 |
| | 100 MHz | >70 | >70 | >70 | >70 | >70 | >70 | >70 |
| | 300 MHz | >70 | >70 | >70 | >70 | >70 | >70 | >70 |
| | 500 MHz | >70 | >70 | >70 | >70 | >70 | >70 | >70 |
| | 1000 MHz | >70 | >70 | >70 | >70 | >70 | >70 | >70 |
| | Viscosity (m – g) | 1400 | 1500 | 1650 | 1480 | 1440 | 1500 | 1550 |

Table 2-4

| | | Example 8 | Example 9 | Example 10 | Example 11 | Example 12 | Example 13 | Example 14 |
|---|---|---|---|---|---|---|---|---|
| Composition | Base Composition (part by wt.) | VCVA1 ... 100<br>DOP ... 50<br>TS ... 5<br>SA ... 3 | PVC1 ... 100<br>NBR ... 20<br>DIDP ... 50<br>LFOS ... 5 | PVC2 ... 100<br>TOTM ... 40<br>DBT ... 8 | PVC3 ... 100<br>TOTM ... 40<br>DBT ... 7 | VCVA1 ... 100<br>DINP ... 45<br>TS ... 7 | VCE1 ... 100<br>DINP ... 45<br>LFOS ... 7 | VCE2 ... 100<br>TCP ... 40<br>Ba·Zn ... 5 |
| | Metal Fiber (% by weight) | brass 6<br>48 | red copper 1<br>50 | pure copper 1<br>50 | pure copper 2<br>50 | red copper 2<br>50 | brass 3<br>50 | brass 3<br>50 |
| Characteristics | Injection Moldability | excellent | excellent | good | good | excellent | excellent | good |
| | Volume Resistivity $\Omega\,cm$ | $3.8 \times 10^{-2}$ | $8 \times 10^{-2}$ | $4.3 \times 10^{-2}$ | $3 \times 10^{-2}$ | $2 \times 10^{-2}$ | $4 \times 10^{-2}$ | $3 \times 10^{-2}$ |
| | Electromagnetic Wave Shielding Effect (dB) — 30 MHz | >70 | >70 | >70 | >70 | >70 | >70 | >70 |
| | 100 MHz | >70 | >70 | >70 | >70 | >70 | >70 | >70 |
| | 300 MHz | >70 | >70 | >70 | >70 | >70 | >70 | >70 |
| | 500 MHz | >70 | >70 | >70 | >70 | >70 | >70 | >70 |
| | 1000 MHz | >70 | >70 | >70 | >70 | >70 | >70 | >70 |
| | Viscosity (m − g) | 1480 | 1250 | 850 | 650 | 1700 | 1450 | 800 |

Table 2-5

| | | Example 15 | Example 16 | Example 17 | Example 18 | Example 19 | Example 20 | Example 21 |
|---|---|---|---|---|---|---|---|---|
| Composition | Base Composition (part by wt.) | VCE3 ... 100<br>TOP .... 40<br>TS ..... 7 | VCU ... 100<br>TPP ... 10<br>TS .... 7 | EVAVC ... 100<br>DOP ..... 10<br>TS ...... 8 | ABS ... 100 | same as left | same as left | VCVA2 ... 100<br>TCP ..... 40<br>TS ...... 10<br>$Sb_2O_3$ ... 10 |
| | Metal Fiber (% by weight) | brass 3<br>50 | brass 2<br>50 | brass 4<br>50 | brass 1<br>55 | brass 2<br>45 | pure copper 1<br>45 | brass 3<br>45 |
| Characteristics | Injection Moldability | good | excellent | excellent | excellent | excellent | excellent | good |
| | Volume Resistivity $\Omega$cm | $2.5 \times 10^{-2}$ | $1 \times 10^{-2}$ | $1 \times 10^{-1}$ | $1.2 \times 10^{-2}$ | $6 \times 10^{-2}$ | $3 \times 10^{-2}$ | $3.8 \times 10^{-2}$ |
| | Electromagnetic Wave Shielding Effect (dB)   30 MHz | >70 | >70 | >70 | >70 | >70 | >70 | >70 |
| | 100 MHz | >70 | >70 | >70 | >70 | >70 | >70 | >70 |
| | 300 MHz | >70 | >70 | >70 | >70 | >70 | >70 | >70 |
| | 500 MHz | >70 | >70 | >70 | >70 | >70 | >70 | >70 |
| | 1000 MHz | >70 | >70 | >70 | >70 | >70 | >70 | >70 |
| | Viscosity (m − g) | 600 | 900 | 1700 | 800 | 750 | 740 | 660 |

Table 2-6

| Composition | | Example 22 | Example 23 |
|---|---|---|---|
| | Base Composition (part by wt.) | VCE2 .... 100<br>TCP ..... 40<br>TS ....... 10<br>$Sb_2O_3$ ... 10 | VCE2 ... 100<br>TCP ..... 50<br>LFOS .... 10<br>AO ....... 10 |
| | Metal Fiber (% by weight) | brass 3<br>45 | same as left |
| Characteristics | Injection Moldability | good | good |
| | Volume Resistivity $\Omega$ cm | $5.2 \times 10^{-2}$ | $5.3 \times 10^{-2}$ |
| | Electromagnetic Wave Shielding Effect (dB) — 30 MHz | >70 | >70 |
| | 100 MHz | >70 | >70 |
| | 300 MHz | >70 | >70 |
| | 500 MHz | >70 | >70 |
| | 1000 MHz | >70 | >70 |
| | Viscosity (m - g) | 720 | 820 |

## What Is Claimed Is:

1. An electromagnetic wave shielding composition characterized in that said composition comprises at least one kind selected from a group consisting of plasticized vinyl chloride resin and acrylonitrile-butadiene-styrene resin, and copper or copper alloy fiber having a diameter of 1 - 100 $\mu$m and a length of 0.5 - 10 mm, wherein the amount of the fiber is 30 - 70 % by weight in content.

2. A composition according to claim 1 wherein said composition is 0.005 - 0.5 $\Omega$ cm in volume resistivity.

3. A composition according to claim 1 or 2 wherein said composition is 200 - 2,000 m - g in viscosity at a temperature of 180°C.

4. A composition according to claim 1 wherein said plasticized vinyl chloride comprises of vinyl chloride copolymer and a plasticizer, said vinyl chloride copolymer being at least 50 % by weight in vinyl chloride content and being 400 - 1,200 in mean degree of polymerization.

5. A composition according to claim 4 wherein said vinyl chloride copolymer is a copolymer of vinyl chloride and at least one kind of monomers, said monomers being capable of effecting radical polymerization with vinyl chloride, wherein said vinyl chloride is 80 - 99.5 % by weight in content.

6. A composition according to claim 1 wherein said copper or copper in said copper alloy is pure copper.

7. A composition according to claim 1 wherein said copper alloy consists essentially of copper and zinc and amounts to 95:5 - 60:40 in a weight ratio of copper to zinc.

0113785

International Application No. PCT/JP83/00238

## I. CLASSIFICATION OF SUBJECT MATTER (if several classification symbols apply, indicate all) [3]

According to International Patent Classification (IPC) or to both National Classification and IPC

Int. Cl.[3] C08L 27/06, C08L 55/02, C08K 7/02, H01B 7/18

## II. FIELDS SEARCHED

| Minimum Documentation Searched [4] | |
|---|---|
| Classification System | Classification Symbols |
| I P C | C08L 27/06, C08L 55/02 |

| Documentation Searched other than Minimum Documentation to the Extent that such Documents are Included in the Fields Searched [5] | |
|---|---|
| Jitsuyo Shinan Koho | 1910 - 1982 |
| Kokai Jitsuyo Shinan Koho | 1971 - 1982 |

## III. DOCUMENTS CONSIDERED TO BE RELEVANT [14]

| Category* | Citation of Document, [16] with indication, where appropriate, of the relevant passages [17] | Relevant to Claim No. [18] |
|---|---|---|
| X | "Plastics Times" No. 1727, July 12, 1982, Chuo Sangyo Shinko Center Kabushiki Kaisha Hakko, Page 1 upper part of left column | 1 |
| X | Patent Laid-open No. 46254/1979, Page 3, left column, lines 19 to 21 | 1 |
| X | Patent Laid-open No. 46253/1979, Page 4, right column, lines 14 to 16 | 1 |

* Special categories of cited documents: [15]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search [2] | Date of Mailing of this International Search Report [2] |
|---|---|
| October 25, 1983 (25. 10. 83) | November 7, 1983 (07. 11. 83) |
| International Searching Authority [1] | Signature of Authorized Officer [20] |
| Japanese Patent Office | |

Form PCT/ISA/210 (second sheet) (October 1981)